# EUROPÄISCHE PATENTSCHRIFT

(11) **EP 0 559 954 B1**
(45) Veröffentlichungstag und Bekanntmachung des Hinweises auf die Patenterteilung: **10.07.1996**
(21) Anmeldenummer: 92117680.6
(22) Anmeldetag: 16.10.1992
(51) Int. Cl.: H01Q 23/00, H03H 11/34

(54) **Aktive Frequenzweiche**
Active frequency band splitter
Séparateur en bande de fréquences actif

(30) Priorität: 13.03.1992 DE 4208062
(43) Veröffentlichungstag der Anmeldung: 15.09.1993
(73) Patentinhaber: ROBERT BOSCH GMBH, 70442 Stuttgart (DE)
(72) Erfinder: Raddant, Hans-Joachim, Dipl.-Ing., W-1000 Berlin 19 (DE)

(56) Entgegenhaltungen:
- EP-A- 0 023 943
- DE-A- 2 443 582
- DE-A- 3 802 810

## Beschreibung

Die Erfindung geht von einer aktiven Frequenzweiche nach dem Oberbegriff des Anspruchs 1 aus.

Es ist eine aktive Frequenzweiche bekannt (DE-PS 38 02 810), deren Vorteil darin besteht, daß für die LMK-Signale eine kapazitive Schadbelastung weitgehend vermieden wird und daß die aktiven Bauelemente von UKW- und LMK-Verstärker durch Signale des jeweils anderen Frequenzbereiches nur unwesentlich beeinflußt werden. Es hat sich jedoch herausgestellt, daß der LMK-Verstärker der bekannten aktiven Frequenzweiche das UKW-Signal etwas abschwächt, weil die Anpaßschaltung des UKW-Verstärkers eingangsseitig üblicherweise eine Serieninduktivität aufweist, die zusammen mit den drei in Serie geschalteten Kondensatoren einen Serienresonanzkreis bildet. Da der mittlere der drei Kondensatoren den kleinsten Kapazitätswert hat, befindet sich der Hochpunkt des Serienresonanzkreises zwischen dem mittleren Kondensator und besagter Induktivität. Durch die hohe Impedanz des Hochpunktes wird das UKW-Signal schon bei verhältnismäßig geringer Belastung abgeschwächt.

Der Erfindung liegt die Aufgabe zugrunde, eine aktive Frequenzweiche nach dem Oberbegriff des Anspruchs 1 derart weiterzubilden, daß eine Abschwächung der UKW-Signale durch den LMK-Verstärker weitgehend vermieden wird.

Diese Aufgabe wird durch die in dem Anspruch 1 angegebenen Merkmale gelöst. Damit ist der Vorteil verbunden, daß die über den Serienresonanzkreis herangeführten UKW-Signale eine deutlich geringere Abschwächung erfahren. Unvermeidbare Streuverluste, die die Verbindungsleitungen und die Anschlußpunkte der Kondensatoren und Induktivitäten der aktiven Frequenzweiche hervorrufen, und Verluste durch die Belastung der UKW-Signale mit dem Feldeffekttransistor bewirken keine Schwächung der UKW-Signale, weil sich der unbeschaltete Hochpunkt des Serienresonanzkreises der aktiven Frequenzweiche zwischen dem zweiten Kondensator und der dazu in Reihe liegenden dritten Induktivität befindet, während der Feldeffekttransistor an den im UKW-Bereich relativ niederohmigen Punkten zwischen den Kondensatoren C1 und C2 bzw. der Induktivität L3 und dem Kondensator C3 angeschlossen ist.

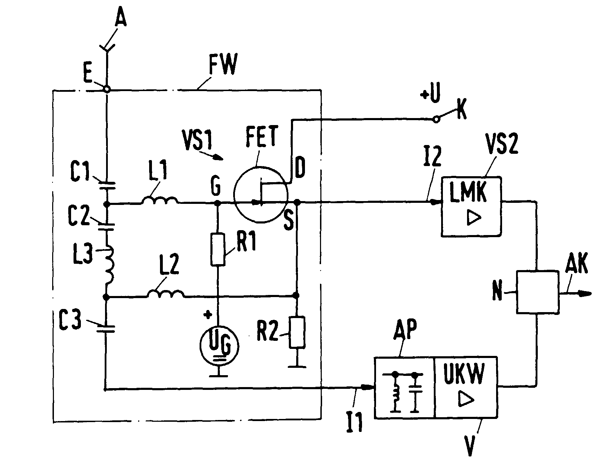

Ein Ausführungsbeispiel der Erfindung ist in der Zeichnung an Hand einer Figur dargestellt und wird im folgenden näher erläutert. In der ein Blockschaltbild der aktiven Frequenzweiche zeigenden Figur bezeichnet A eine Antenne, das ist vorzugsweise eine Fahrzeugantenne, deren Länge für den Empfang von LMK-Signalen im Vergleich zu der mittleren Betriebswellenlänge der zu empfangenden Frequenzen kurz ist.

Der Fußpunkt der Antenne A ist mit einem Eingang E einer aktiven Frequenzweiche FW verbunden, die eine Serienschaltung aus einem ersten Kondensator C1, einem zweiten Kondensator C2, einer dritten Induktivität L3 und einem dritten Kondensator C3 aufweist, der mit einem Eingang I1 eines UKW-Verstärkers V für Signalfrequenzen des UKW-Bereiches in Verbindung steht. Dem UKW-Verstärker V ist eine Anpaßschaltung AP vorgeschaltet, die zum Beispiel einen Querkondensator und eine Querinduktivität, jedoch eingangsseitig keine Serieninduktivität aufweist. Eine erste Induktivität L1 verbindet einen Schaltungspunkt zwischen dem ersten und dem zweiten Kondensator C1 und C2 mit einer Gate-Elektrode G eines in Drain-Schaltung betriebenen Feldeffekttransistors FET, der eine erste Verstärkerstufe VS1 für die Signalfrequenzen des LMK-Bereiches bildet.

Die Drain-Elektrode D des Feldeffekttransistors FET ist mit einem Anschluß K positiven Potentials und die Gate-Elektrode G über einen Widerstand R1 mit einer Gleichspannungsquelle +UG verbunden. Zwischen der dritten Induktivität L3 und dem dritten Kondensator C3 zweigt eine zweite Induktivität L2 ab, die erstens mit der Source-Elektrode S, zweitens mit einem Eingang I2 einer zweiten Verstärkerstufe VS2 für Signalfrequenzen des LMK-Bereiches und drittens über einen Widerstand R2 mit Masse verbunden ist. Die Ausgänge der beiden Verstärkerstufen VS1 und VS2 sind vorzugsweise mit den Eingängen eines Entkopplungsnetzwerkes N verbunden, an dessen Ausgang sich ein Antennenkabel AK anschließt.

Die vorstehend beschriebene Schaltung hat folgende Funktion.

Für die UKW-Signale des von der Antenne A gelieferten Empfangssignals bildet die Reihenschaltung aus den Kondensatoren C1, C2, C3 und der dritten Induktivität L3 einen niederohmigen Weg zu dem Eingang I1 des UKW-Verstärkers V. Die Induktivitäten L1 und L2 sind so bemessen, daß sie für die UKW-Signalspannnung einen hohen Widerstand darstellen, so daß diese Spannung im wesentlichen nur durch den UKW-Verstärker V verstärkt wird.

Die Kondensatoren C1, C2, C3 sind so bemessen, daß der Wert von C3 nur etwa ein Drittel bis ein Viertel der Werte von C1 und C2 beträgt. Dadurch ist die UKW-Resonanzfrequenz des Serienresonanzkreises C1, C2, C3, L3 im wesentlichen von L3 und C2 abhängig, und der Hochpunkt dieses Kreises liegt auf der sehr kurzen und damit streuverlustarmen Verbindung von C2 mit L3. Der Feldeffekttransistor FET zur Verstärkung der LMK-Signale ist an zwei Punkten des Serienresonanzkreises C1, C2, C3, L3 angeschlossen, die wegen ihrer kleineren UKW-Impedanz im Vergleich zum Hochpunkt des Serienresonanzkreises deutlich unkritischer auf Streuverluste reagieren.

Die LMK-Signale gelangen über den ersten Kondensator C1 und die erste Induktivität L1 an die Gate-Elektrode G des Feldeffekttransistors FET und über den zweiten Kondensator C2, die dritte Induktivität L3 und die zweite Induktivität L2 an die Source-Elektrode S. Die Induktivitäten L1, L2 und L3 bilden für die LMK-Signale einen verhältnismäßig geringen Widerstand, so daß der zweite Kondensator C2 bei diesen Frequenzen unmittelbar zwischen Source- und Gate-Elektrode S und G liegt und eine Mitkopplung bewirkt.

Mit der Gleichspannungsquelle +UG und dem Widerstand R1 wird die Vorspannung für den Feldeffekttransistor FET gebildet. Die zwischen Source-Elektrode S des Feldeffekttransistors FET und Masse liegende LMK-Spannung wird in der zweiten Verstärkerstufe VS2 weiterverstärkt.

Durch die erwähnte Mitkopplung wird der Kondensator C2 für LMK-Signale dynamisch verkleinert und damit die Schadbelastung der LMK-Signale durch den UKW-Verstärker V verringert. Auf diese Weise kann der Kondensator C2 relativ groß gemacht werden - dies ist für eine gute Ankopplung des UKW-Verstärkers notwendig -, ohne daß sich eine nennenswerte Schadkapazität ergibt. Somit läßt sich sowohl für LMK- als auch für UKW-Signale ein guter Signal/Rausch-Abstand erreichen.

In einer verbesserten Ausführung wird der Widerstand R2 durch eine dem Fachmann aus anderen Anwendungen bekannte Konstantstromquelle ersetzt. Dadurch erhöht sich die Spannungsverstärkung des Feldeffekttransistors FET auf einen Wert nahe 1. Der Wert des Kondensators C2 wird dynamisch weiter verringert, desgleichen die Belastung des LMK-Signals durch den UKW-Verstärker. Als Resultat erhöht sich das LMK-Signal an der Gate-Elektrode G des Feldeffekttransistors FET.

Ein Abgleich der Frequenzweiche ist weder in dem LMK-Zweig mit dem Feldeffekttransistor FET, den Induktivitäten L1, L2, L3 und den Kondensatoren C1, C2 noch in dem UKW-Zweig mit den drei in Reihe liegenden Kondensatoren C1, C2, C3 und der dritten Induktivität L3 erforderlich.

Die Ausgangsspannungen des UKW-Verstärkers V und des die Verstärkerstufen VS1 und VS2 umfassenden LMK-Verstärkers werden über das Entkopplungsnetzwerk N zusammengeführt und über das Antennenkabel AK dem Eingang eines Autoradios zugeführt.

An die Stelle des Feldeffekttransistors FET kann gegebenenfalls auch ein Bipolar-Transistor treten.

## Patentansprüche

1. Aktive Frequenzweiche mit einem Feldeffekttransistorverstärker, die die mit einer Empfangsantenne (A) empfangenen Signale in einen höheren Frequenzbereich und einen niedrigeren Frequenzbereich aufteilt, wobei der Fußpunkt der Empfangsantenne erstens über eine Reihenschaltung aus einem ersten, zweiten und dritten Kondensator (C1 .. C3) mit dem Eingang einer Anpaßschaltung (AP) eines ersten Verstärkers für Signale des höheren Frequenzbereiches, zweitens über den ersten Kondensator und eine damit in Reihe liegende erste Induktivität (L1) mit der Gate-Elektrode eines eine erste Verstärkerstufe (VS1) für den niedrigeren Frequenzbereich bildenden Feldeffekttransistors (FET) und drittens über den ersten und den zweiten Kondensator und eine damit in Reihe liegende zweite Induktivität (L2) mit der Source-Elektrode des Feldeffekttransistors sowie mit dem Eingang einer zweiten Verstärkerstufe (VS2) für Signale des niedrigeren Frequenzbereiches und über einen Widerstand (R2) mit Masse verbunden ist, **dadurch gekennzeichnet**, daß zwischen dem zweiten Kondensator (C2) und dem dritten Kondensator (C3) eine dritte Induktivität (L3) geschaltet ist die mit dem zweiten Kondensator (C2) einen Serienresonanz kreis bildet, der auf den höheren Frequenzbereich abgestimmt ist, daß zwischen der dritten Induktivität (L3) und dem dritten Kondensator (C3) die zweite, mit der Source-Elektrode (S) des Feldeffekttransistors (FET) verbundene Induktivität (L2) abzweigt und daß die Anpaßschaltung (AP) keine Serieninduktivität enthält.

2. Aktive Frequenzweiche nach Anspruch 1, dadurch gekennzeichnet, daß der Widerstand (R2) durch eine Konstantstromquelle ersetzt ist.

3. Aktive Frequenzweiche nach Anspruch 1, dadurch gekennzeichnet, daß der Feldeffekttransistor (FET) durch einen bipolaren Transistor ersetzt ist.

## Claims

1. Active frequency separating filter having a field-effect transistor amplifier, which frequency separating filter divides up signals received with a reception antenna (A) into a higher frequency range and a lower frequency range, the base of the reception antenna being connected firstly to the input of a matching circuit (AP) of a first amplifier for signals of the higher frequency range via a series circuit comprising a first, second and third capacitor (C1..C3), secondly to the gate electrode of a field-effect transistor (FET), which forms a first amplifier stage (VS1) for the lower frequency range, via the first capacitor and a first inductor (L1) which is in series with it, and thirdly to the source electrode of the field-effect transistor and to the input of a second amplifier stage (VS2) for signals of the lower frequency range via the first and second capacitors and a second inductor (L2) which is in series with them, and to earth via a resistor (R2), characterized in that connected between the second capacitor (C2) and the third capacitor (C3) is a third inductor (L3) which forms a series resonant circuit with the second capacitor (C2), which series resonant circuit is tuned to the higher frequency range, in that the second inductor (L2) which is connected to the source electrode (S) of the field-effect transistor (FET) branches off between the third inductor (L3) and the third capacitor (C3), and in that the matching circuit (AP) does not contain a series inductor.

2. Active frequency separating filter according to Claim 1, characterized in that the resistor (R2) is replaced by a constant current source.

3. Active frequency separating filter according to Claim 1, characterized in that the field-effect transistor (FET) is replaced by a bipolar transistor.

## Revendications

1. Séparateur de fréquences actif, avec un amplificateur à transistor à effet de champ qui répartit les signaux reçus par une antenne réceptrice (A) en une gamme de fréquences supérieures et une gamme de fréquences inférieures, la base de l'antenne réceptrice étant reliée en premier lieu par l'intermédiaire d'un montage en série, constitué d'un premier, d'un second et d'un troisième condensateur (C1 ... C3), à l'entrée d'un montage d'adaptation (AP) d'un premier amplificateur pour les signaux de la gamme de fréquences supérieures, en second lieu, par l'intermédiaire du premier condensateur et d'une première inductance (L1) placée en série avec lui, à l'électrode de grille d'un transistor à effet de champ (FET) constituant un premier étage amplificateur (VS1) pour la gamme des fréquences inférieures, et en troisième lieu, par l'intermédiaire du premier et du second condensateur et d'une seconde inductance (L2) placée en série avec eux, à l'électrode de source du transistor à effet de champ ainsi qu'à l'entrée d'un second étage amplificateur (VS2) pour les signaux de la gamme de fréquences inférieures, et par une résistance (R2) la masse,
séparateur de fréquences caractérisé en ce qu'entre le second condensateur (C2) et le troisième condensateur (C3) est branchée une troisième inductance (L3) formant avec le second condensateur (C2) un circuit de résonance série qui est accordé sur la gamme des fréquences supérieures, en ce qu'entre la troisième inductance (L3) et le troisième condensateur (C3) est branchée la seconde inductance (L2) reliée à l'électrode de source (S) du transistor à effet de champ (FET), et en ce que le montage d'adaptation (AP) ne contient pas d'inductance série.

2. Séparateur de fréquences actif selon la revendication 1, caractérisé en ce que la résistance (R2) est remplacée par une source de courant constant.

3. Séparateur de fréquences actif selon la revendication 1, caractérisé en ce que le transistor à effet de champ (FET) est remplacé par un transistor bipolaire.
